# EUROPÄISCHE PATENTSCHRIFT

(11) **EP 0 763 745 B1**
(45) Veröffentlichungstag und Bekanntmachung des Hinweises auf die Patenterteilung: **17.06.2009**
(21) Anmeldenummer: 96890145.4
(22) Anmeldetag: 18.09.1996
(51) Int. Cl.: G01R 19/02, G01R 31/02, G01R 27/18, G01R 27/20

(54) **Verfahren und Vorrichtung zur Prüfung von elektrischen Geräten mit Schutzleiter**
Method and device for testing electrical apparatus with protective earth
Procédé et appareil de test des appareils électriques avec conducteur de terre

(30) Priorität: 18.09.1995 AT 154495
(43) Veröffentlichungstag der Anmeldung: 19.03.1997
(73) Patentinhaber: Lem Norma GmbH, 2345 Brunn am Gebirge (AT)
(72) Erfinder: Gebhart, Walter, 2371 Hinterbrühl (AT); Steuer, Ronald, 2371 Hinterbrühl (AT)
(74) Vertreter: Köhler-Pavlik, Johann

(56) Entgegenhaltungen:
- EP-A- 0 046 024
- EP-A- 0 532 345
- EP-A- 0 613 018
- EP-A- 0 636 893
- DE-A- 4 332 649
- GB-A- 2 164 756
- GB-A- 2 277 598
- US-A- 4 004 221
- US-A- 4 857 855
- US-A- 4 884 034
- US-A- 5 349 289
- US-A- 5 461 317

## Beschreibung

Die Erfindung betrifft ein Verfahren und eine Vorrichtung zur Reparatur- und Wiederholungsprüfung von elektrischen Geräten mit einem berührbaren Gehäuse und mit einem Schutzleiter.

Gemäß den Sicherheitsbestimmungen sind elektrische oder elektronische Geräte nach deren Reparatur oder Instandsetzung, aber auch in gewissen Zeitabständen routinemäßig, beispielsweise geregelt in der Norm ISO 9000 auf ihre Betriebssicherheit zu prüfen. Dabei kommen auch netzversorgte Prüfgeräte zum Einsatz, bei denen gemäß den bisher üblichen Messverfahren die zu testenden Verbraucher vom Versorgungsnetz galvanisch getrennt sein müssen und das Prüfgerät zwischen Netz und Verbraucher geschaltet werden. Für die Funktionsprüfung muss dabei in einem Fall eine separate Steckdose verwendet werden, wodurch das Prüfgerät voluminöser und schwerer wird und zusätzlich der Vorteil der elektronischen Verriegelung bei nicht erfüllter Sicherheitsprüfung entfällt. Es kann aber auch eine kombinierte Steckdose verwendet werden, wobei der Schutzleiter geschaltet werden muß. Z.B US 5 461 317A und EP 0 613 018A offenbaren Vorrichtungen und Verfahren für Ableitstrom- bzw. Isolationsmessungen.

Im Fehlerfall, d.h. z.B. einem Isolationsfehler beim Funktionstest, können aber bis zum Abschalten Ströme bis zu 600 A fließen, sodass zusätzliche elektronische Schutzmaßnahmen für den Schalterkontakt notwendig sind. Dessen ungeachtet kann ein geschalteter Schutzleiter nie den Sicherheitsgrad eines kontinuierlich verbundenen Schutzleiters erreichen.

Andererseits kann bei angeschlossenem Schutzleiter die Messung in nachteiliger Weise durch zum Schutzleiter parallele Erdschlüsse beeinflusst werden. Außerdem ist die Kenntnis eines vorliegenden Erdschlusses für die Auswahl der richtigen folgenden Messmethode bzw. für die umfassende sicherheitsmäßige Beurteilung von Bedeutung. In vielen Bereichen ist auch eine Trennung der Verbraucher vom Netz, speziell für regelmäßige Wiederholungsprüfungen aus betriebs- oder sicherheitstechnischen Gründen unerwünscht oder mit größerem Aufwand verbunden, so etwa im EDV-Bereich, wo bei einer Trennung vom Netz die Gefahr von Datenverlusten besteht oder deswegen aufwendige Sicherungsmaßnahmen ergriffen werden müssen.

Auch bei Geräten ohne Schutzleiter gilt das oben Gesagte über die negative Beeinflussung der Messung während der Prüfung durch allfällige parallele Erdschlüsse und es kann in gleicher Weise bei derartigen Verbrauchern aus betriebs- oder sicherheitstechnischen Gründen unerwünscht oder mit größerem Aufwand verbunden sein, diese vom Netz trennen zu müssen.

In jedem Fall bietet eine Prüfung bei ans Versorgungsnetz angeschlossenem Verbraucher zeitmäßige und wirtschaftliche Vorteile und/oder die Prüfung mit verbundenem Schutzleiter sicherheitstechnische Vorteile. Fix angeschlossene Gerät sind mit den derzeitigen Prüfmethoden überhaupt nur schwer oder unvollständig erfassbar.

Aufgabe der vorliegenden Erfindung ist daher die Schaffung eines Verfahrens, bei dem der zu prüfende Verbraucher während der Prüfung mit dem Schutzleiter verbunden sein kann und dabei Einflüsse von parallelen Erdverbindungen wie Wasseranschlüssen etc., die ein Überschreiten der zulässigen Betriebsmessabweichung bei der Ermittlung des Schutzleiterwiderstandes oder des Ableitstromes verursachen würden, festgestellt werden können.

Eine weitere Aufgabe war die Schaffung eines Prüfgeräts zur Durchführung des Verfahrens, welches das Vorliegen von parallelen Erdverbindungen ermittelt, anzeigt und allenfalls deren Werte misst oder die Prüfung mit diesen Werten korrigiert.

Zur Lösung der ersten Aufgabe ist erfindungsgemäß ein Verfahren nach dem Anspruch 1 vorgesehen. Ein über das berührbare Gehäuse des elektrischen Geräts eingespeister Prüfstrom und vorzugsweise gleichzeitig der über den Schutzleiter des Gerätes fließende Strom gemessen und verglichen werden, wobei zumindest das Vorliegen einer, einen vorbestimmten Grenzwert übersteigenden Differenz angezeigt wird. Eine derartige Vorgangsweise gestattet auch im Falle eines Isolationsfehlers in weiterer Folge einen für die prüfende Person sicheren Prüfungsablauf, bei welcher zusätzlich das Vorliegen eines zum Verbraucher parallelen Erdschlusses ermittelt und dem überprüfenden Fachmann signalisiert werden kann.

Vorteilhafterweise kann dabei auch der Spannungsabfall des über den Schutzleiter fließenden Stromes gemessen und daraus der Wert eines allfälligen parallelen Erdwiderstandes bestimmt werden, sodass sofort in einfacher Weise die Korrektur des während der Überprüfung ermittelten Wertes für den Schutzleiterwiderstand erfolgen kann.

Das zweite angegebene Ziel der vorliegenden Erfindung wird durch eine Vorrichtung nach dem Anspruch 4 gelöst. Zur Reparatur- und Wiederholungsprüfung von elektrischen Geräten mit einem berührbaren Gehäuse und mit einem Schutzleiter ohne Trennung des Schutzleiters ist die Vorrichtung mit zumindest einer optischen Anzeigeeinrichtung, mit einem Schutzleiteranschluss zur Verbindung mit dem Schutzleiter des Gerätes, mit einem weiteren Anschluss zur Verbindung mit dem Schutzleiteranschluss des Versorgungsnetzes, wobei zwischen dem Anschluss und dem Schutzleiteranschluss einer Strommessvorrichtung zur Messung des Schutzleiterstromes vorgesehen ist, weiters mit einer Konstantstromquelle zum Einprägen eines Prüfstromes über eine Prüfspitze an das berührbare Gehäuse des elektrischen Gerätes, und einer Strommesseinrichtung zur Ermittlung des eingeprägten Prüfstromes ausgerüstet. Dadurch kann eine kombinierte Prüfsteckdose gebaut werden, die mit einem direkt verbundenen Schutzleiter.versehen ist und bei der die messtechnischen Nachteile durch Beeinflussung der Messung bei Parallelerdungen durch das erfindungsgemäße Messverfahren angezeigt oder korrigiert wird. Der während der Messung angeschlossene Schutzleiter sorgt dabei für erhöhte Sicherheit, da doch im Fehlerfall Ströme bis zu 600 A auftreten können.

Gemäß einem weiteren Merkmal der Erfindung können zwei optische Anzeigeeinrichtungen vorgesehen und je eine davon mit einer Strommesseinrichtung verbunden sein. Diese Ausführungsform gestattet die direkte Ablesung des Prüfstromes und des Schutzleiterstromes, wobei eine allfällige Differenz dieser Werte direkt die Stärke des parallelen Erdschlußstromes ergibt.

Wenn beide Strommesseinrichtungen mit einer Einrichtung zum Vergleichen der beiden ermittelten Stromstärken und diese mit der zumindest einen optischen Anzeigeeinrichtung verbunden sind ist, ist eine komfortablere und auch gegenüber Rechenfehlern sichere Überprüfung gewährleistet.

Um noch den Widerstand der parallelen Erdverbindung ermitteln zu können, ist vorteilhafterweise eine Spannungsmesseinrichtung zur Messung des Spannungsabfalls, zwischen dem Schutzleiteranschluss und der Prüfspitze vorgesehen.

In der nachfolgenden Beschreibung werden Beispiele unter Bezugnahme auf die beiliegenden Zeichnungen näher beschrieben. Dabei zeigen
Fig. 1a eine schematische Darstellung einer Summenstrommessung mittels einer Stromzange bei fix am Versorgungsnetz angeschlossenem Verbraucher,
Fig. 1b eine erweiterte Variante der Fig. 1a,
Fig. 2 eine Variante der Differenzstrommessung bzw. Schutzleiterstrommessung bei einem Gerät mit getrennt verlegtem Schutzleiter und mit einer anderen Überprüfungs-Vorrichtung,
Fig. 3 eine schematische Darstellung einer Berührungsstrom-Messung mit einer Stromzange,
Fig. 4a eine schematische Darstellung eines Prüfgerätes nach der Erfindung mit Schutzleiteranschluss und Konstantstromquelle,
Fig. 4b eine vorteilhafte, erweiterte Ausführungsform des Gerätes aus Fig. 4a,
Fig. 5a eine Variante des Gerätes gemäß Fig. 4a mit Wechselstromversorgung und
Fig. 5b eine erweiterte, vorteilhafte Ausführungsform des Gerätes aus Fig. 5a.

In Fig.. 1a - wie auch in den übrigen Zeichnungen - ist das berührbare Gehäuse des zu prüfenden Gerätes V mit 1 bezeichnet und dessen elektrischer Teil ist über die Anschlussleitung 2 mit dem Außenleiter L sowie über die Leitung 3 mit dem Neutralleiter N des Versorgungsnetzes (Außenleiter L und Neutralleiter N sind die sogenannten aktiven Leiter) verbunden. Weiters ist noch ein Schutzleiter 4 vorgesehen, der leitend mit den berührbaren Teilen 1 des Gerätes V und mit dem Schutzleiterteil PE des Netzes verbunden ist. Diese Verbindungsleitungen 2, 3, 4 können dabei fix installiert und mit Netz und Verbraucher V verbunden oder über ein System von Netz-Steckdose, Kabel mit Anschluss-Stecker und Geräte-Steckdose oder Fixanschluß am Gerät V verwirklicht sein. Mittels einer Stromzange 5 mit einer angeschlossenen, vorzugsweise optischen Anzeigeeinrichtung 6 für die Stromstärke werden zur Messung des Differenzstromes (Außenleiter-, Neutralleiter- und Schutzleiterstrom) die Leitungen 2, 3, 4 gleichzeitig umgriffen, welche gebräuchlicherweise in einem Kabel zusammengefasst sind. Sollte ein durch strichlierte Darstellung symbolisierter Erdschluss beispielsweise Wasseranschlüsse des Gerätes V od. ähnliches, vorliegen, wird ein Überschreiten der unteren Meßgrenze der Stromzange 5 durch diesen Erdschlussstrom und vorteilhafterweise gleich auch von dessen Stromstärke I_{E} auf der Anzeigeeinrichtung 6 signalisiert. Bei Kenntnis der Spannung zwischen Gehäuse 1 des Verbrauchers V und der Erdung kann auch der Erdschluss-Widerstand R_{E} ermittelt werden.

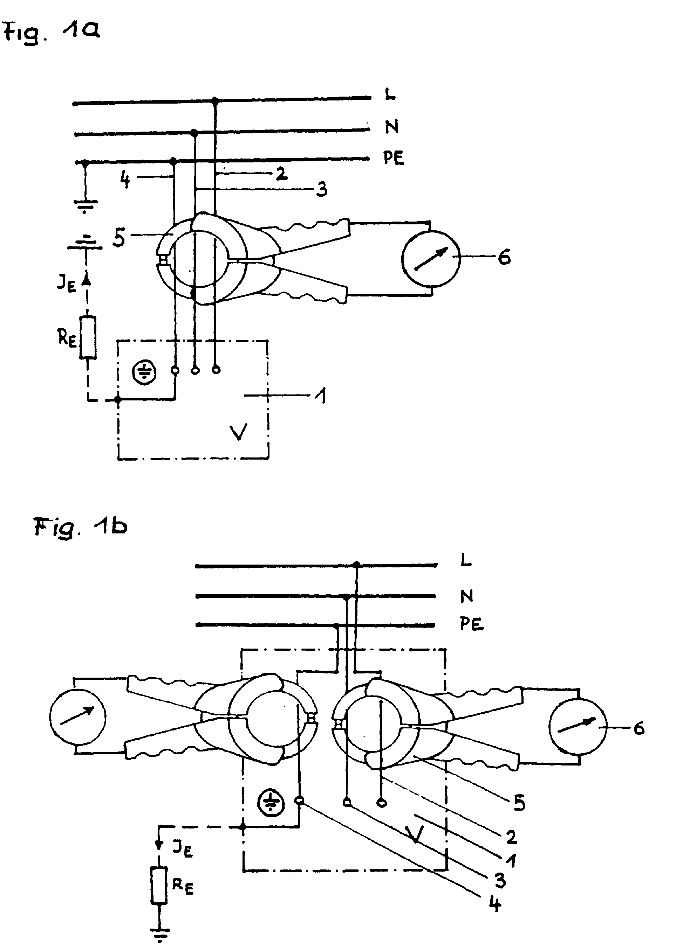

Gemäß der in Fig. 1b dargestellten Variante kann anschließend wieder mittels der Stromzange 5 der Differenzstrom als Summe der Ströme durch die aktiven Leiter 2, 3 ermittelt, mit einem vorgegebenen Grenzwert verglichen und zumindest das Übersteigen des Grenzwertes durch den Differenzstrom auf der Anzeigeeinrichtung 6 der Stromzange 5 angezeigt werden. Schließlich kann abschließend, speziell wenn die Messung der Momentanwerte der aktiven Leiter 2, 3 keinen Differenzstrom - Stromsumme gleich Null - ergibt, noch der Schutzleiterstrom durch den Leiter 4 gemessen werden. Wegen der gemeinsamen Verlegung der Leiter 2, 3, 4 werden diese Messungen vorzugsweise innerhalb des geöffneten Gehäuses 1 des Verbrauchers V vorgenommen. Falls es die Konstruktion des Gerätes V jedoch nicht gestattet, insbesondere bei fix am Netz angeschlossenen Verbrauchern V, können die beschriebenen Messungen auch netzseitig durchgeführt werden.

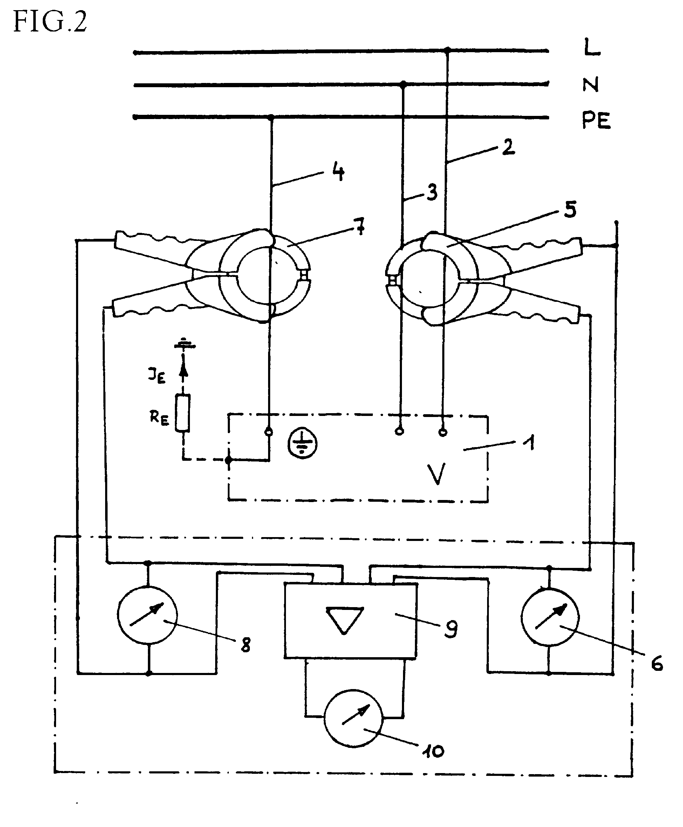

Eine mögliche Vorgangsweise zur Überprüfung von Geräten V, bei welchen der Schutzleiter 4 getrennt von den Anschlussleitungen 2, 3 zur Stromversorgung, die aber gemeinsam in einem Kabel geführt sind, verlegt ist, ist in Fig. 2 dargestellt. Dabei wird von einer Stromzange 5 mit Anzeigeeinrichtung 6 das Kabel mit den Leitungen 2, 3 umgriffen und die Summe aus Außenleiter- und Neutralleiterstrom ermittelt und vorteilhafterweise auch deren Stromstärke I_{Δ} angezeigt. Von einer zweiten Stromzange 7 wird gleichzeitig für eine Messung und vorteilhafterweise auch Anzeige des Schutzleiterstromes T_{PE} auf der Anzeigeeinrichtung 8 der Stromzange 7 der Schutzleiter 4 umgriffen. Dabei sind die beiden Stromzangen 5 und 7 bzw. deren Messschaltungen mit einer Einrichtung 9 zur Differenzbildung zwischen den beiden gemessenen Strömen und vorteilhafterweise auch gleich zur Anzeige des Vorliegens und allenfalls der Größe dieser Differenz verbunden. Die besagte Anzeige könnte auch auf einer der vorhandenen Anzeigeeinrichtungen 6, 8 der Stromzangen 5, 7 erfolgen. Die Anzeigeeinrichtungen 6, 8, 10 und die Differenzbildungs-Einrichtung 9 können auch mit Verstärkern, Treiberkreisen für die Anzeigen und weiteren derartigen bei Meß- und Anzeigevorrichtungen üblichen Baugruppen versehen sein. Anstelle der gleichzeitigen Messung des Schutzleiterstromes I_{PE} mit einer zweiten Messzange 7 kann dieser Strom auch durch eine zeitlich auf die Messung des Differenzstromes I_{Δ} folgende zweite Messung mit nur einer Stromzange 5 ermittelt werden. Dabei weist die Stromzange 5 oder deren Anzeigeeinrichtung 6 vorteilhafterweise eine Speichereinrichtung und allenfalls sogar noch eine Einrichtung zur Differenzbildung zwischen zwei gespeicherten Werten auf, sodass in einfacher und sicherer Weise und ohne zusätzliche Hilfsmittel ein paralleler Erdschlussstrom, I_{E} durch automatische Differenzbildung I_{Δ} - I_{PE} ermittelt und dessen Stromstärke angezeigt werden kann. Dabei könnten in weiteren Variationen des Verfahrens mit einer Stromzange hintereinander alle drei Leitungen 2, 3, 4 gemessen und anschließend die Gesamtdifferenz ermittelt oder mit drei Stromzangen alle drei Leitungen 2, 3, 4 gleichzeitig aber einzeln gemessen werden.

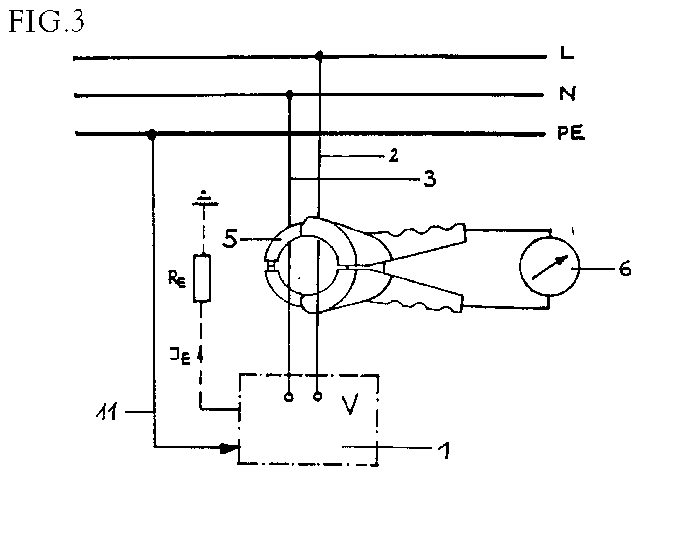

Bei fix angeschlossenen Geräten V ohne Schutzleiter - oder bei Geräten, die aus bestimmten Gründen nicht vom Versorgungsnetz getrennt werden dürfen oder sollen - kann gemäß der schematischen Darstellung der Fig. 3 das allfällige Vorhandensein eines Erdschlusses - wieder strichliert dargestellt - mit Stromstärke I_{E} und durch nachfolgende zweite Messung der Berührungsstrom festgestellt werden. Zuerst wird bei normal aufgestelltem Gerät V, d.h. wie im bestimmungsmäßigen Betrieb vorgesehen, der Differenzstrom zwischen Außenleiter- und Neutralleiterstrom durch gleichzeitiges Umgreifen der Leitungen 2, 3 - allenfalls auch durch zeitlich aufeinanderfolgendes einzelnes Umgreifen der Leitungen - der Differenzstrom ermittelt, der gleichzeitig dem Erdschlussstrom I_{E} entspricht. Danach wird das Gehäuse 1 des Gerätes V durch Verbinden mit dem Schutzleiterteil PE des Versorgungsnetzes über die Prüfspitze 11 geerdet und nochmals der Differenzstrom zwischen Außenleiter- und Neutralleiterstrom gemessen, wobei durch diese Erdung nun definitionsgemäß der Berührungsstrom ermittelt wird, der aber im ungünstigsten realen Fall noch um den Erdschlussstrom vermehrt wäre, weshalb dessen Kenntnis durch die erste Messung hier von besonderer Bedeutung ist.

Während sich die bisher erläuterten Beispiele auf fix mit dem Versorgungsnetz verbundene Verbraucher V oder solche Geräte bezogen haben, bei welchen eine Trennung vom Netz nicht erwünscht oder nicht möglich ist, beispielsweise EDV-Anlagen, Sicherheitseinrichtungen od. dgl., speziell im Fall einer routinemäßigen Wiederholungsprüfung und nicht nach einer ohnehin die Trennung erfordernden Reparatur, zeigen die nachfolgend erläuterten Beispiele die Vorgangsweise bei lediglich angeschlossenem Schutzleiter.

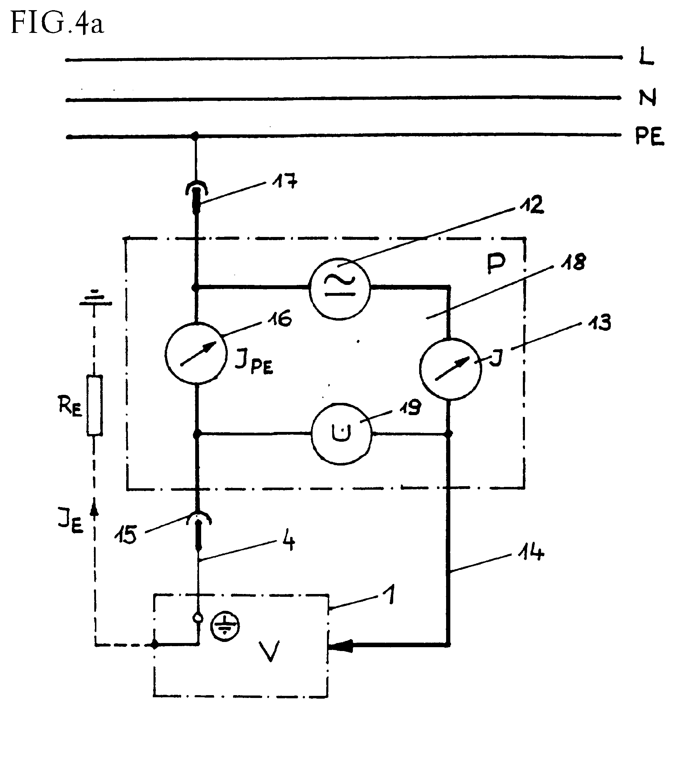

Das in Fig. 4a schematisch dargestellte Prüfgerät 11 enthält eine Konstantstromquelle 12, welche über eine Strommesseinrichtung 13, die auch zur optischen Anzeige der Stromstärke ausgelegt sein kann, und eine Prüfspitze 14 einen Prüfstrom I an das Gehäuse 1 des vom Netz L, N, PE galvanisch getrennten Gerätes V legt. In sicherheitstechnisch vorteilhafter Weise ist der Schutzleiter 4 des Gerätes V bei der Überprüfung mit einem Schutzleiteranschluss 15 des Prüfgerätes 11 verbunden. Dieser Schutzleiteranschluss 15 führt über eine Strommessvorrichtung 16, vorzugsweise einen Ringwandler, zu einem weiteren Anschlussteil PE des Netzes. Mittels der Strommessvorrichtung 16 wird der Schutzleiterstrom I_{PE} ermittelt und allenfalls getrennt vom Prüfstrom I angezeigt. Bei Vorliegen einer Differenz der beiden Ströme I, I_{PE} ist dies ein Anzeichen für einen parallelen Erdschluss - wieder durch strichlierte Darstellung symbolisiert - und dessen Stromstärke I_{E} ergibt sich aus der Differenz der Ströme I - I₁.

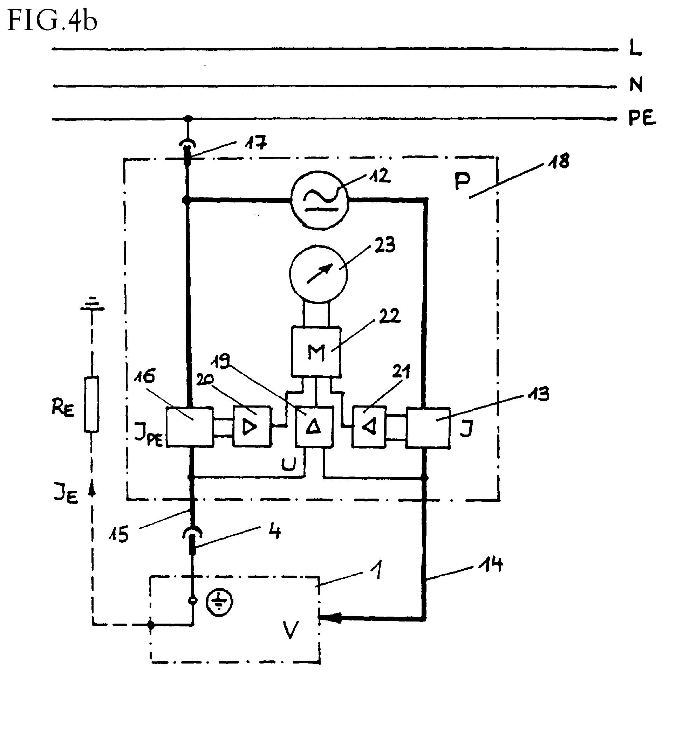

Diese Differenz kann - wie dies in Fig. 4b zum Ausdruck kommt - vorteilhafterweise auch durch im Prüfgerät 18 befindliche Schaltungen oder Baugruppen ermittelt und auf allenfalls nur einer einzigen Anzeigeeinrichtung 23 des Prüfgerätes 18 angezeigt werden. Dabei werden die Meßgrößen für die Ströme I und I_{PE} jeweils einer Verstärkerschaltung 20 bzw. 21 zugeführt, welche ihrerseits mit einer Rechenschaltung 22 zum Vergleich der beiden Stromstärkewerte verbunden sind. Auf einer einzigen, mit der Rechenschaltung 22 verbundenen optischen Anzeigeeinrichtung 23 wird dann die in der Schaltung 22 ermittelte Differenz I - I_{PE} angezeigt. Selbstverständlich können bei entsprechender Steuerung der Rechenschaltung 22, gegebenenfalls über Bedienungselemente beeinflussbar, alle ermittelten und errechenbaren Werte einzeln angezeigt werden. Das Prüfgerät 18 kann auch weitere vorteilhafte und an sich bekannte Elemente aufweisen, beispielsweise Speichereinrichtungen für die Messwerte, Verstärker, Anzeigetreiber und dgl.

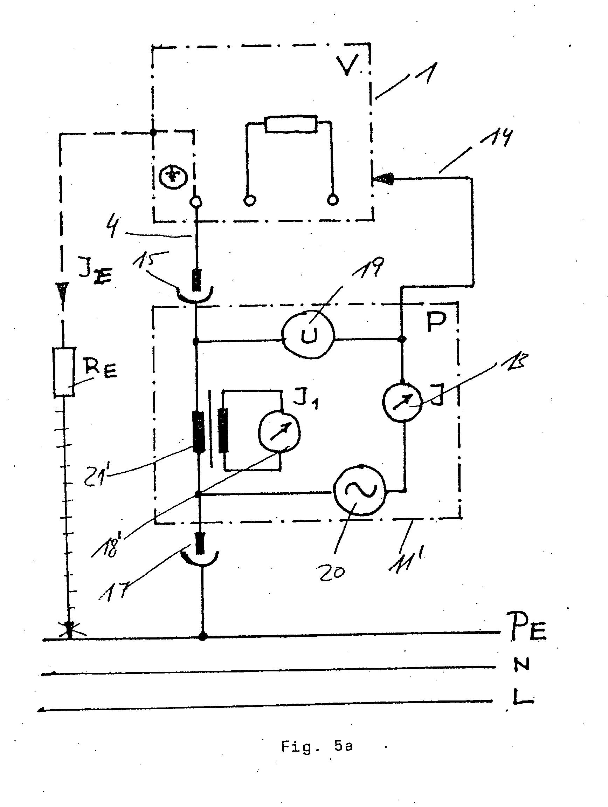

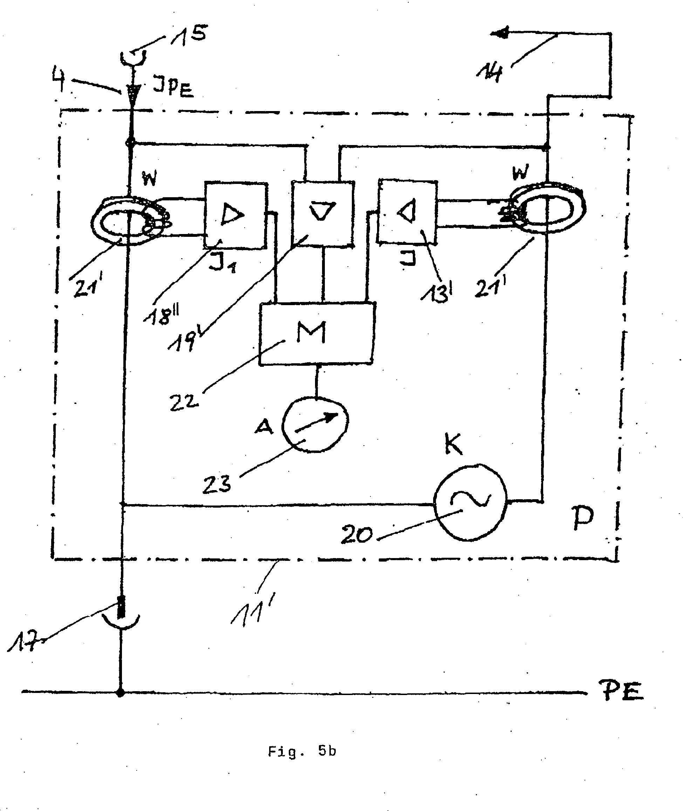

Eine andere Ausführungsform des Prüfgerätes 11' mit Wechselstrom-Versorgung zeigt die Fig. 5a, wobei hier die Konstantstromquelle 12 durch eine Wechselstromquelle 20 ersetzt ist. Zur Ermittlung des Schutzleiterstromes I₁ ist im wechselstromversorgten Prüfgerät 11' ein Ringwandler 21' mit zugehöriger Abtastspule und Strommesseinrichtung 18' vorgesehen. Die von den Ringwandlern 21' ermittelten Meßgrößen für die Ströme I und I₁ können gemäß Fig. 5b auch jeweils einer Verstärkerschaltung 13' bzw. 18' zugeführt werden, welche ihrerseits wiederum mit einer Rechenschaltung 22 zum Vergleich der beiden Stromstärkewerte verbunden sind. Auf einer einzigen, mit der Rechenschaltung 22 verbundenen optischen Anzeigeeinrichtung 23 wird dann die in der Schaltung 22 ermittelte Differenz I - I₁ angezeigt. Selbstverständlich können wiederum bei entsprechender Steuerung der Rechenschaltung 22, gegebenenfalls über Bedienungselemente beeinflussbar, alle ermittelten und errechenbaren Werte einzeln angezeigt werden.

Um noch in vorteilhafter Weise sofort den Widerstandswert des parallelen Erdschlusses ermitteln und allenfalls automatisch berechnen und anzeigen zu können, ist eine Spannungsmesseinrichtung 19 im Prüfgerät 18, 11' vorgesehen und zwischen Prüfspitze 14 und Schutzleiteranschluss 15 geschaltet. Im Falle der erweiterten Ausführungsformen des Prüfgerätes 18 kann der Messwert für die Spannung U auch einer Verstärkerschaltung 19' zugeführt werden, welche ebenfalls mit der Rechenschaltung 22 verbunden ist, sodass auf der Anzeigeeinrichtung 23 der Spannungswert bzw. der Widerstandswert direkt angezeigt werden können.

## Patentansprüche

1. Verfahren zur zur Reparatur- und Wiederholungsprüfung von elektrischen Geräten (V) mit einem berührbaren Gehäuse (1) und mit einem Schutzleiter (4) ohne Trennung des Schutzleiters (4), bei dem ein über das berührbare Gehäuse (1) des elektrischen Geräts (V) eingespeister Prüfstrom (I) und der über den Schutzleiter (4) des Gerätes (V) fließende Strom (I_{PE}) gemessen und verglichen werden, wobei zumindest das Vorliegen einer, einen vorbestimmten Grenzwert übersteigenden Differenz angezeigt wird.

2. Verfahren nach Anspruch 1, **dadurch gekennzeichnet, dass** der eingespeiste Prüfstrom (I) und der über den Schutzleiter (4) des Gerätes (V) fließende Strom (I_{PE}) gleichzeitig gemessen und verglichen werden.

3. Verfahren nach Anspruch 1 oder 2, **dadurch gekennzeichnet, dass** der Spannungsabfall (U) des über den Schutzleiter (4) fließenden Stromes (I_{PE}) gemessen und daraus der Wert eines allfälligen parallelen Erdwiderstandes (R_{E}) bestimmt wird.

4. Vorrichtung zur Reparatur- und Wiederholungsprüfung von elektrischen Geräten (V) mit einem berührbaren Gehäuse (1) und mit einem Schutzleiter (4) ohne Trennung des Schutzleiters (4) nach einem der Ansprüche 1 bis 3, mit zumindest einer optischen Anzeigeeinrichtung (23), einem Schutzleiteranschluss (15) zur Verbindung mit dem Schutzleiter (4) des Gerätes (V), mit einem weiteren Anschluss (17) zur Verbindung mit dem Schutzleiteranschluss (PE) des Versorgungsnetzes, wobei zwischen dem Anschluss (17) und dem Schutzleiteranschluss (15) eine Strommessvorrichtung (16) zur Messung des Schuzleiterstromes (I_{PE}) vorgesehen ist, weiters mit einer Konstantstromquelle (12, 20) zum Einprägen eines Prüfstromes (I) über eine Prüfspitze (14) an das berührbare Gehäuse (1) des elektrischen Gerätes (V), und einer Strommesseinrichtung (13) zur Ermittlung des eingeprägten Prüfstromes (I).

5. Vorrichtung nach Anspruch 4, **dadurch gekennzeichnet, dass** zwei optische Anzeigeeinrichtungen (23) vorgesehen und je eine davon mit einer Strommesseinrichtung (13, 16) verbunden ist.

6. Vorrichtung nach Anspruch 4, **dadurch gekennzeichnet, dass** beide Strommesseinrichtungen (13, 16) mit einer Einrichtung (22) zum Vergleichen der beiden ermittelten Stromstärken (I, I_{PE}) und diese mit der zumindest einen optischen Anzeigeeinrichtung (23) verbunden sind.

7. Vorrichtung nach einem der Ansprüche 4 bis 6, **dadurch gekennzeichnet, dass** zur Ermittlung eines allfälligen parallelen Erdwiderstandes (R_{E}) eine Spannungsmesseinrichtung (19) zur Messung des Spannungsabfalls (U) zwischen dem Schutzleiteranschluss (15) und der Prüfspitze (14) vorgesehen ist.

## Claims

1. A method for repair and repetitive testing of electric devices (V), which include a contactable housing (1) and a protective conductor (4), without separation of the protective conductor (4), wherein a testing current (I) fed via the contactable housing (1) of the electric device (V) and the current (I_{PE}) flowing via the protective conductor (4) of the device (V) are measured and compared, wherein at least the presence of a difference which exceeds a predefined threshold value will be indicated.

2. The method according to claim 1, **characterized in that** the testing current (I) fed and the current (I_{PE}) flowing via the protective conductor (4) of the device (V) are measured simultaneously and compared.

3. The method according to claim 1 or 2, **characterized in that** the voltage drop (U) of the current (I_{PE}) flowing via the protective conductor (4) is measured, and the value of a possibly present, parallel ground resistance (R_{E}) is determined therefrom.

4. A device for repair and repetitive testing of electric devices (V), which include a contactable housing (1) and a protective conductor (4), without separation of the protective conductor (4) according to any one of claims 1 to 3, including at least one optical display means (23), a protective-conductor connection (15) for connection to the protective conductor (4) of the device (V), a further connection (17) for connection to the protective-conductor connection (PE) of the supply grid, with a current-measuring unit (16) being provided between the connection (17) and the protective-conductor connection (15) for measuring the protective-conductor current (I_{PE}), furthermore including a constant-current source (12, 20) for impressing a testing current (I) via a test prod (14) to the contactable housing (1) of the electric device (V), and including a current-measuring unit (13) for detecting the testing current (I) impressed.

5. The device according to claim 4, **characterized in that** two optical display means (23) are provided, each of which being connected to a current-measuring unit (13, 16).

6. The device according to claim 4, **characterized in that** both current-measuring units (13, 16) are connected to a device (22) for comparing the two current intensities (I, I_{PE}) detected and to the at least one optical display means (23).

7. The device according to any one of claims 4 to 6, **characterized in that** a voltage-measuring unit (19) is provided between the possibly present, parallel ground resistance (R_{E}) for measuring the voltage drop (U) between the protective-conductor connection (15) and the test prod (14).

## Revendications

1. Procédé pour les essais après réparation et les essais récurrents d'appareils électriques (V) avec un boîtier accessible (1) et avec un conducteur de protection (4) sans séparation du conducteur de protection (4), dans lequel un courant d'essai (I) injecté par l'intermédiaire du boîtier accessible (1) de l'appareil électrique (V) et le courant (I_{PE}) circulant à travers le conducteur de protection (4) de l'appareil (V) sont mesurés et comparés, dans lequel au moins la présence d'une différence dépassant une valeur limite prédéterminée est affichée.

2. Procédé selon la revendication 1, **caractérisé en ce que** le courant d'essai (I) injecté et le courant (I_{PE}) circulant à travers le conducteur de protection (4) de l'appareil (V) sont mesurés en même temps et comparés.

3. Procédé selon la revendication 1 ou 2, **caractérisé en ce que** la chute de tension (U) du courant (I_{PE}) circulant à travers le conducteur de protection (4) est mesurée et à partir de celle-ci la valeur d'une résistance de terre parallèle (R_{E}) éventuelle est déterminée.

4. Dispositif pour les essais après réparation et les essais récurrents d'appareils électriques (V) avec un boîtier accessible (1) et avec un conducteur de protection (4) sans séparation du conducteur de protection (4) selon l'une quelconque des revendications 1 à 3, avec au moins un dispositif d'affichage optique (23), une borne de conducteur de protection (15) pour une connexion avec le conducteur de protection (4) de l'appareil (V), avec une autre borne (17) pour une connexion avec la borne de conducteur de protection (PE) du réseau d'alimentation, dans lequel entre la borne (17) et la borne de conducteur de protection (15), un dispositif de mesure de courant (16) est prévu pour mesurer le courant de conducteur de protection (I_{PE}), en outre avec une source de courant constant (12, 20) pour appliquer un courant d'essai (I) par l'intermédiaire d'une pointe d'essai (14) au boîtier accessible (1) de l'appareil électrique (V), et un dispositif de mesure de courant (13) pour déterminer le courant d'essai (I) appliqué.

5. Dispositif selon la revendication 4, **caractérisé en ce que** deux dispositifs d'affichage optique (23) sont prévus et respectivement l'un deux est relié à un dispositif de mesure de courant (13, 16).

6. Dispositif selon la revendication 4, **caractérisé en ce que** les deux dispositifs de mesure de courant (13, 16) sont reliés à un dispositif (22) pour comparer les deux intensités de courant déterminées (I, I_{PE}), et celui-ci est relié audit au moins un dispositif d'affichage optique (23).

7. Dispositif selon l'une quelconque des revendications 4 à 6, **caractérisé en ce que** pour la détermination d'une résistance de terre parallèle (R_{E}) éventuelle, un dispositif de mesure de tension (19) pour mesurer la chute de tension (U) est prévu entre la borne de conducteur de protection (15) et la pointe d'essai (14).
